# EUROPEAN PATENT APPLICATION

(11) **EP 4 543 149 A1**
(43) Date of publication of application: **23.04.2025**
(21) Application number: 23204345.5
(22) Date of filing: 18.10.2023
(51) Int. Cl.: H05K 5/02, H05K 9/00

(54) **CABLE ENTRY ARRANGEMENT, ELECTROMAGNETICALLY SHIELDED CONTAINER AND SATELLITE TERMINAL**

(71) Applicant: Ovzon Sweden AB, 171 54 Solna (SE)
(72) Inventor: LEJNELL, Kennet, 171 54 SOLNA (SE); WESTER, Fredrik, 125 43 ÄLVSJÖ (SE)
(74) Representative: Brann AB

(57) **Abstract**

A cable entry arrangement passes the conductors of a cable (200) into an electromagnetically shielded container (500). The cable entry arrangement receives the cable (200) with a symmetry axis thereof being parallel to a wall (510) of the container (500). The cable entry arrangement (100) includes a base member (115) and at least one sealing member (525). The base member (115) contains a channel (125) adapted to lead the cable (200) with its symmetry axis parallel to the wall (510) from an inlet end (126) of the base member (115) to a through-opening (515) in the wall (510). The at least one sealing member (525) retains the cable (200) in the channel (125) and galvanically connects a cable shielding (210) of the cable (200) to the wall (510).

## Description

### TECHNICAL FIELD

The invention relates generally to reduction of electromagnetic interference and electromagnetic shielding. In particular, the present invention concerns a cable entry arrangement according to the preamble of claim 1. The invention also relates to an electromagnetically shielded container including the proposed cable entry arrangement and a satellite terminal that, in turn, includes such an electromagnetically shielded container.

### BACKGROUND

With an ever-increasing amount of electronic devices, the electromagnetic spectrum becomes more and more crowded. With this comes the need to keep electrical components shielded from each other to avoid electromagnetic interference (EMI). EMI occurs because of unwanted electromagnetic waves or signals disturbing a proper functioning of electrical devices. It is often referred to as electromagnetic noise, or just noise. Electromagnetic radiation at any frequency may cause interference. EMI in the radio frequency domain, i.e. 3 kHz to 300 GHz, is often called radio frequency interference (RFI). EMI may originate from various sources, which can be divided into two main categories: natural and man-made sources. The category of natural sources includes astronomical phenomena, lightning strikes, solar flares, static electricity, cosmic noise, dust storms, and snowstorms. The category of man-made sources includes different kinds of electronic and electrical devices, which emit electromagnetic radiation that affects devices and equipment within their vicinity. Man-made EMI may further be categorized as either unintentional or intentional. Electric motors, generators, lightings, rectifiers, inverters, satellite communication devices and transmission lines constitute examples of unintentional sources of man-made EMI that may disrupt other nearby devices in connection with switching large electrical currents. In this case, the emission of electromagnetic radiation is purely incidental. However, electronic devices using wireless signals, such as mobile phones/cell-phones, laptops, Bluetooth mice and speakers, wireless routers, and remote controls are sources of RFI. These devices emit electromagnetic radiation intentionally. Nevertheless, the radiation is spread substantially more than to the intended recipients of the wireless signals. Moreover, due an overall increased throughput demand, the general frequency of the emitted energy increases, and larger amounts of electromagnetic radiation is discharged into the surroundings. Other examples of intentional RFI sources are radars, jamming devices, and radio transmitters.

One way to protect electronic devices from EMI and RFI is to use the Faraday cage principle by implementing radio frequency (RF) shielding to safeguard devices and equipment from the harmful effects brought by RF interference. A Faraday cage is a continuous and conductive enclosure made of wire mesh or screens that blocks static and non-static electromagnetic fields. It distributes the electromagnetic waves around the exterior of the cage. Without an electric field, the electric charges within the conductive cage are evenly distributed around the material. When an external electric field is applied to the cage, it causes the charges to redistribute, creates electron flow around the cage and a secondary electric field in the opposite direction is created. As a result, the incoming fields are cancelled. Hence, the net electric field inside the Faraday cage is zero.

In addition to protecting electronic devices from EMI and RFI, electric signals need to be communicated with these devices. The circuit board of an electronic device is typically encapsulated in an electrically conductive box. The box acts as a shield, which prevents radiated (airborne) interferences from reaching the circuit board. In addition, the shielding provided by electrically conductive box prevents potentially interfering signals generated inside the box from escaping there from. Inter alia, this is important to comply with various regulatory requirements, e.g. the CE (Conformite Européene) Mark.

To supply voltage and exchange control and traffic signals to the circuit board, one or more cables need to be routed through the wall of the box. If not properly designed, there is a risk that these cable entries form leakage points in the shield. The market offers countless of connectors and cable glands that provide through-hull cabling with maintained shielding. Below follows same examples of such designs.

US 8,963,015 shows a solution for cable's point of entry to an enclosure, where a shield of the cable is AC coupled around an entire opening of the enclosure using a discoidal capacitor. The capacitor may be electrically coupled to the shield and the enclosure around the entire inner and outer circumferences of the discoidal capacitor. Compared to traditional DC coupling or the use of a drain wire and traditional capacitor, using the discoidal capacitor lowers inductance and improves shielding of the opening itself while improving AC filtering characteristics and preventing ground loops.

US 9,419,426 discloses a sealing-member-equipped shielded cable with a shielded cable that includes shielded wires and a sealing member that is molded from a resin and that includes an electrically conductive member in at least a portion thereof. The sealing member is integrally formed on one end portion of the shielded cable, and the shielded wires are electrically connected to the electrically conductive member of the sealing member.

US 10,966,357 describes an electromagnetic shielding device including at least one hollow protective textile sleeve having a main rest diameter D1 and an interior volume configured to receive one or several elongated element(s), and at least one hollow connecting textile sleeve having a rest diameter D2, where D2 greater than D1. The protective textile sleeve includes a substantially annular front part having a front open end. The connecting textile sleeve includes a substantially annular rear part having a rear open end, and the shielding device includes a first electrically conductive securing area in which the rear part of the connecting sleeve and the front part of the protective sleeve are at least partly secured.

The above designs may efficiently protect the signals of electronic devices from EMI and RFI. However, in addition to shielding electronic components from electromagnetic interferences, in many implementations there is a general compactness requirement, in particular for mobile equipment. Therefore, further challenges exist.

The known solutions for passing cables into electromagnetically shielded container are often relatively big and heavy. To enable the development of small and portable terminals, for example for satellite communication, analogous to other components, the size of the cables and connectors must be spatially efficient. Today, the cables and connectors often place the hardest restrictions on how much it is possible to shrink the size of a terminal. A cable gland/connector extending straight out from the wall of a container is very inefficient in terms of the volume occupied by the connected cable, inter alia because cable cannot be bent very sharply. Also if the cable extends from the wall in a rounded bend, it risks being damaged by neighboring components, for example in the production process when mounting components at short distances from one another, and or in connection with attaching a lid to a component box.

Another problem with the known connectors is that they risk to gradually vibrate loose during use, which leads to potential problems with deteriorated signal quality, or even loss of signal.

### SUMMARY

One object of the present invention is therefore to solve the above problems and offer a slim and small-sized arrangement for passing cables into an electromagnetically shielded container in an uncomplicated and durable manner that neither jeopardizes the quality of the signals passing through the cables, nor the signals that are processed in the container.

According to one aspect of the invention, the object is achieved by a cable entry arrangement for passing at least one conductor of a cable into an electromagnetically shielded container. The cable entry arrangement is adapted to receive the cable with a symmetry axis thereof being parallel to a wall of the electromagnetically shielded container. The cable entry arrangement includes a base member and at least one sealing member. The base member has a channel adapted to lead the cable with its symmetry axis parallel to the wall from an inlet end of the base member to a through-opening in a wall of the electromagnetically shielded container. The at least one sealing member is adapted to retain the cable in the channel and galvanically connect a cable shielding of the cable to the wall of the electromagnetically shielded container.

This cable entry arrangement is advantageous because it allows for an overall reduced product size, for example of a mobile satellite terminal, where EMI and RFI shielded components may be arranged close to one another in a highly volume efficient manner and a minimum risk that the interconnecting cables are damaged during manufacture or use of the product.

According to one embodiment of this aspect of the invention, the at least one sealing member includes an electrically conductive epoxy resin, e.g. containing copper, nickel and/or aluminum that is connected to the cable shielding and mechanically fixes the cable in the channel. Thus, the Faraday cage provided by the container may remain intact, and at the same time, cables may pass there through in a convenient and reliable manner.

According to embodiments of this aspect of the invention, in addition to or as an alternative to the electrically conductive epoxy resin, the at least one sealing member includes an electrically conductive lid, e.g. at least partially made of aluminum that is mounted over the base member to cover a portion of the cable shielding located in the channel, and mechanically fix the cable in the channel. Thereby, both the cable and the opening in the container are very efficiently shielded from EMI and RFI. Any electrically conductive epoxy resin is here placed between the cable shielding and the electrically conductive lid to enhance the EMI/RFI shielding and the mechanical protection of the cable.

According to another embodiment of this aspect of the invention, the electrically conductive lid includes a compressing member configured to contact the cable shielding of the cable when the cable is placed in the channel and apply a pressure to the cable. Thus, the cable is secured to the base member in a manner that both provides mechanical relief for the cable and shields the cable through-hole from EMI/RFI.

Preferably, the compressing member protrudes from an inside surface of the electrically conductive lid, and the compressing member includes a groove surface adapted to contact the cable shielding when the cable is placed in the channel. Thereby, the compressing member may follow a rounded outline of the cable and attain good galvanic contact with the cable shielding.

It is especially advantageous if the compressing member is adapted to contact the cable shielding of the cable at the inlet end of the base member when the cable is placed in the channel and thus close an electromagnetic shielding around the cable, which electromagnetic shielding is galvanically connected to the electromagnetically shielded container. Namely, this is beneficial for the electromagnetic environment both inside and outside of the container. For the same reasons, it is advantageous if the compressing member extends along an entire length of the channel.

According to other embodiments of this aspect of the invention, the groove surface of the lid and/or a contact surface of the channel has a serrated pattern adapted to grip into the cable shielding of the cable when the cable is placed in the channel and the lid is mounted over the base member. This namely further enhances the mechanical attachment of the cable to the cable entry arrangement.

According to yet another embodiment of this aspect of the invention, the electrically conductive lid contains at least one through-hole configured to receive a respective screw, and the base member contains at least one threaded hole matching the at least one through-hole when the electrically conductive lid is mounted on the base member. Here, the at least one threaded hole is adapted to receive the respective screws for fastening the electrically conductive lid to the base member. As a result, it is straightforward to assemble the lid on the base member, and disassemble the lid from the base member should this be necessary at a later stage.

According to still another embodiment of this aspect of the invention, the base member forms an integral part of the wall of the electromagnetically shielded container, for example by being cast in a mold common to the base member and the wall. This minimizes the risk of EMI/RFI leakage between base member and the electromagnetically shielded container.

According to another aspect of the invention, the object is achieved by an electromagnetically shielded container with at least one wall that includes at least one instance of the proposed cable entry arrangement.

According to yet another aspect of the invention, the object is achieved by a satellite terminal, which, in turn, includes the above electromagnetically shielded container and at least one cable that is lead through the at least one wall via the proposed cable entry arrangement.

The advantages of the electromagnetically shielded container and the satellite terminal, as well as the preferred embodiments thereof, are apparent from the discussion above with reference to the proposed cable entry arrangement.

Further advantages, beneficial features and applications of the present invention will be apparent from the following description and the dependent claims.

### BRIEF DESCRIPTION OF THE DRAWINGS

The invention is now to be explained more closely by means of preferred embodiments, which are disclosed as examples, and with reference to the attached drawings.
- Figure 1: shows an electromagnetically shielded container and a base member according to one embodiment of the invention;
- Figure 2: shows a cable with conductors that are enclosed in a cable shielding;
- Figures 3a-d: show electrically conductive lids according to different embodiments of the invention;
- Figures 4a-b: exemplify serrated patterns of a contact surface in a channel of the base member, which serrated patterns are adapted to grip into the cable shielding of the cable according to embodiments of the invention;
- Figures 5-6: illustrate how different sealing members may be arranged on the base member according to embodiments of the invention; and
- Figure 7: shows a satellite terminal including a proposed electromagnetically shielded container with a cable entry arrangement according to one embodiment of the invention.

### DETAILED DESCRIPTION

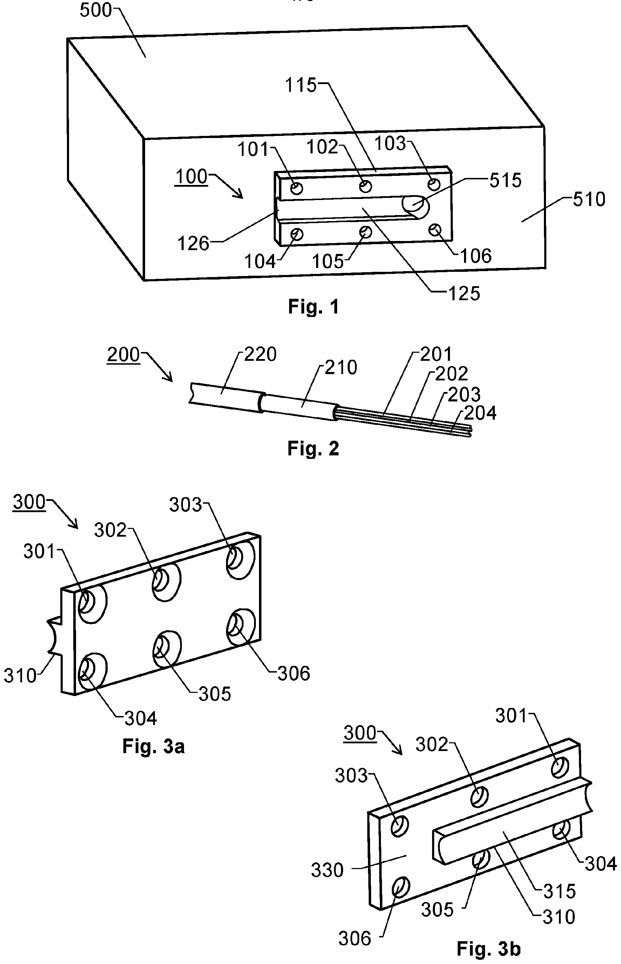

Figure 1 shows an electromagnetically shielded container 500 and a base member 115 according to one embodiment of the invention. Figure 2 shows a cable 200 with conductors 201, 202, 203 and 204 respectively that are enclosed in a cable shielding 210.

The base member 115 forms part of a cable entry arrangement 100 for passing at least one of the conductors 201, 202, 203 and/or 204 of the cable 200 into the electromagnetically shielded container 500 through a wall 510 thereof.

According embodiments of the invention, the base member 115 may either form an integral part of the wall 510, for example by being cast in a mold common to the base member 115 and the wall 510, or be a component that is separately mounted onto the wall 510. The former design minimizes the risk of EMI/RFI leakage between base member 115 and the electromagnetically shielded container 500, while the latter design provides flexibility in terms of whether and where to add a cable connection to the electromagnetically shielded container 500.

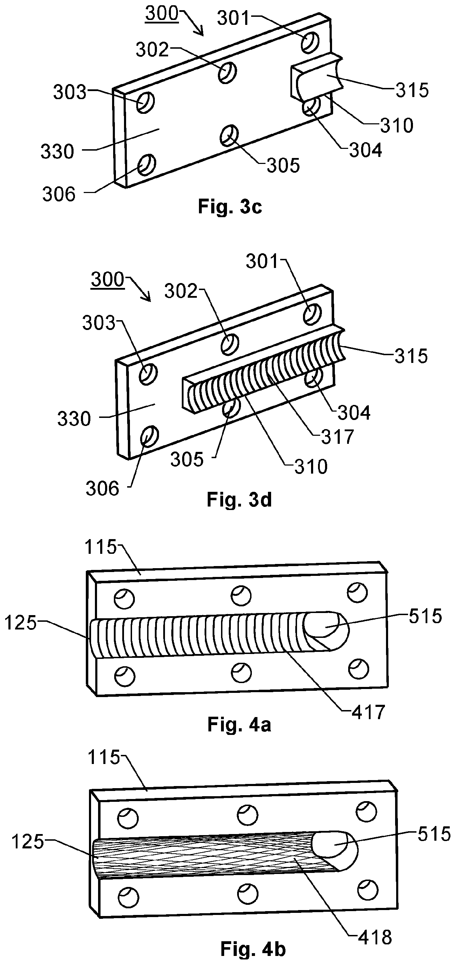

The cable entry arrangement 100 is adapted to receive the cable 200 with a symmetry axis thereof being parallel to the wall 510 of the electromagnetically shielded container 500. According to the invention, the cable entry arrangement 100 contains a base member 115 and at least one sealing member, which will be described below referring to Figures 3a to 3d and 5 to 7.

The base member 115 contains a channel 125 adapted to lead the cable 200 with its symmetry axis parallel to the wall 510 from an inlet end 126 of the base member 115 to a through-opening 515 in the wall 510 of the electromagnetically shielded container 500. The at least one sealing member is adapted to retain the cable 200 in the channel 125 and galvanically connect the cable shielding 210 of the cable 200 to the wall 510 of the electromagnetically shielded container 500 so as to maintain the Faraday cage provided by the container 500.

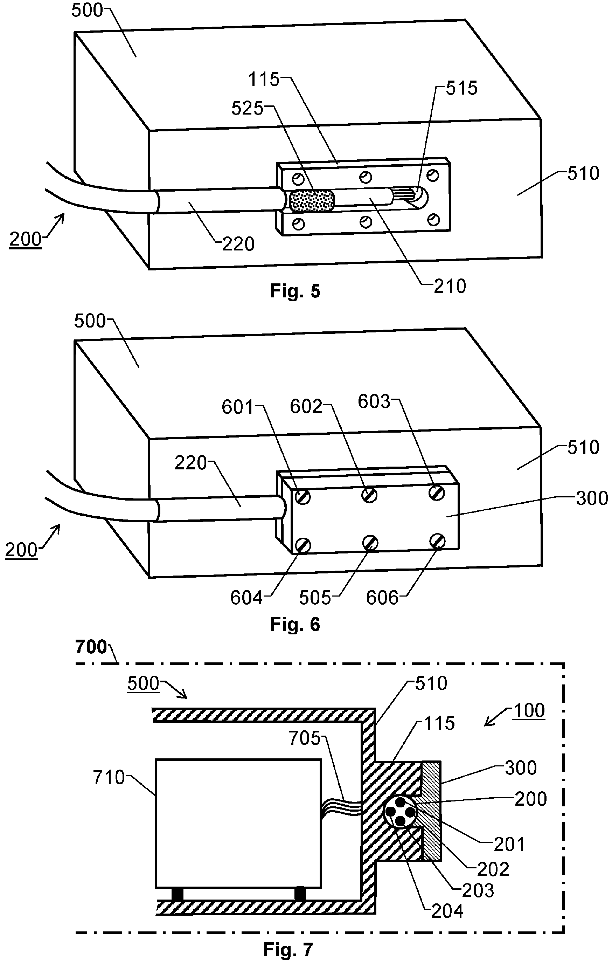

Referring now to Figure 5, we see how the cable 200 is placed in the channel 125 and its conductors 201, 202, 203 and 204 are passed into the electromagnetically shielded container 500 via the through-hole 515. Figure 5 also shows a sealing member in the form of an electrically conductive epoxy resin 525 that is connected to the cable shielding 210 and mechanically fixes the cable 200 in the channel 125. Preferably, for mechanical reasons and to provide good EMI/RFI shielding, the electrically conductive epoxy resin 525 should cover the cable shielding 210 and the conductors 201, 202, 203 and 204 along an entire extension of channel 125 up to the through-opening 515. However, for clarity reasons, the electrically conductive epoxy resin 525 here only covers a region of the channel 125 near the inlet end 126 of the base member 115. According to embodiments of the invention, the electrically conductive epoxy resin 525 contains a suitable amount of copper, nickel and/or aluminum to attain desired conductive characteristics. However, naturally, other electrically conductive additives in the epoxy resin 525are also conceivable.

As an alternative, or in addition to the electrically conductive epoxy resin 525, the at least one sealing member may be represented by an electrically conductive lid 300 that covers the cable 200, the cable shielding 210 and the conductors 201, 202, 203 and 204 in the base member 115, and mechanically fixes the cable 200 to the base member 115.

Figures 3a to 3d show electrically conductive lids 300 according to different embodiments of the invention. The electrically conductive lid 300 may contain a set of through-holes 301, 302, 303, 304, 305 and 306 respectively configured to receive a respective screw 601, 602, 603, 604, 605 and 606 (see Figure 6) to allow a straightforward assembly of the lid 300 on the base member 115, as well as a straightforward disassembly of the lid 300 from the base member 115 should so be necessary at a later stage. To this aim, the base member 115 may preferably contain a set of threaded holes 101, 102, 103, 104, 105 and 106 respectively that match the through-holes 301, 302, 303, 304, 305 and 306 respectively when the electrically conductive lid 300 is mounted on the base member 115. Here, each of the threaded holes is adapted to receive a respective one of the screws 601, 602, 603, 604, 605 and 606 to fasten the electrically conductive lid 300 to the base member 115. Corresponding screws may also be useful to seal the electrically conductive box 500 itself. In particular, an EMI/RFI tight sealing is crucial if high-frequency signals and generated and/or processed inside the box 500, and such a sealing, in turn, may require numerous screws to avoid any undesired gaps.

For cost-efficiency and weight reasons, the electrically conductive lid 300 may be made of aluminum, at least partially. However, of course, basically any other electrically conductive material is conceivable.

Inter alia, the electrically conductive lid 300 functions as a cover over a portion of the cable shielding 210 that is located in the channel 125 to shield the cable 200 and the through-hole 515 from EMI/RFI. The electrically conductive lid 300 also fixes the cable 200 mechanically in the channel 125, and thus provides mechanical relief for the cable 200.

For improved performance of the above functions, it is beneficial if the electrically conductive lid 300 contains a compressing member 310, which is configured to contact the cable shielding 210 of the cable 200 when the cable 200 is placed in the channel 125 and apply a pressure to the cable 200, so that the cable 200 is clamped between the electrically conductive lid 300 and the channel 125.

The compressing member 310 protrudes from an inside surface 330 of the electrically conductive lid 300. For improved mechanical and electrical contact, the compressing member 310 may have a groove surface 315 with a shape adapted to contact the cable shielding 210 when the cable 200 is placed in the channel 125.

Preferably, the compressing member 310 is adapted to contact the cable 200, its shielding 210 and its conductors 201, 202, 203 and 204 along an entire extension of the channel 125 from the inlet end 126 to the through-hole 515 as illustrated in Figure 3b.

At least, the compressing member 310 should be adapted to contact the cable shielding 210 at the inlet end 126 when the cable 200 is placed in the channel 125, and thus close an electromagnetic shielding around the cable 200, which electromagnetic shielding is galvanically connected to the electromagnetically shielded container 500.

Further, for improved mechanical and electrical contact between the shielding 210 of the cable 200 and the electromagnetically shielded container 500, it is advantageous if at least one of a contact surface of the channel 125 and the groove surface 315 has a serrated pattern. Figures 3d and 4a exemplify a pattern of radial indentations, or cuts 317 and 417 respectively, in the groove surface 315 of the compressing member 310 and the contact surface of the channel 125 respectively. Figure 4b shows an alternative serrated pattern 418 in the form of diamond-shaped cuts in the contact surface of the channel 125.

A common feature of the serrated patterns is that each of them is adapted to grip into the cable shielding 210 of the cable 200 when the cable 200 is placed in the channel 125 and the lid 300 is mounted over the base member 115. Naturally, any type of serrated pattern in addition to the ones illustrated here is conceivable as well as any combination of patterns in the groove surface 315 and the contact surface of the channel 125 respectively.

Figure 6 shows the electrically conductive lid 300 when mounted on the base member 115 and fastened thereto via the screws 601, 602, 603, 604, 605 and 606 respectively. Thus, the electrically conductive lid 300 and the base member 115 form a Faraday cage around the cable 200 and the through-hole 515 into the electromagnetically shielded container 500.

Figure 7 shows a cross section side view of the electromagnetically shielded container 500, the base member 115 and the electrically conductive lid 300 in Figure 6.

Figure 7 also shows electronic circuitry 710 inside the electromagnetically shielded container 500, which electronic circuitry 710 is connected to the conductors 201, 202, 203 and 204 of the cable 200 via cabling 705. In other words, the wall 510 of the electromagnetically shielded container 500 includes the above-described cable entry arrangement 100 through which the electronic circuitry 710 may communicate signals over the cable 200.

The electronic circuitry 710, in turn, forms part of a satellite terminal 700, which, owing to the slim cable entry arrangement 100, can be made small-sized and volume efficient.

Variations to the disclosed embodiments can be understood and effected by those skilled in the art in practicing the claimed invention, from a study of the drawings, the disclosure, and the appended claims.

The term "comprises/comprising" when used in this specification is taken to specify the presence of stated features, integers, steps or components. The term does not preclude the presence or addition of one or more additional elements, features, integers, steps or components or groups thereof. The indefinite article "a" or "an" does not exclude a plurality. In the claims, the word "or" is not to be interpreted as an exclusive or (sometimes referred to as "XOR"). On the contrary, expressions such as "A or B" covers all the cases "A and not B", "B and not A" and "A and B", unless otherwise indicated. The mere fact that certain measures are recited in mutually different dependent claims does not indicate that a combination of these measures cannot be used to advantage. Any reference signs in the claims should not be construed as limiting the scope.

It is also to be noted that features from the various embodiments described herein may freely be combined, unless it is explicitly stated that such a combination would be unsuitable.

The invention is not restricted to the described embodiments in the figures, but may be varied freely within the scope of the claims.

## Claims

1. A cable entry arrangement (100) for passing at least one conductor (201, 202, 203, 204) of a cable (200) into an electromagnetically shielded container (500), which cable entry arrangement (100) is adapted to receive the cable (200) with a symmetry axis thereof being parallel to a wall (510) of the electromagnetically shielded container (500), **characterized in that** the cable entry arrangement (100) comprises:
a base member (115) with a channel (125) adapted to lead the cable (200) with its symmetry axis parallel to the wall (510) from an inlet end (126) of the base member (115) to a through-opening (515) in a wall (510) of the electromagnetically shielded container (500), and
at least one sealing member (525, 300) adapted to retain the cable (200) in the channel (125) and galvanically connect a cable shielding (210) of the cable (200) to the wall (510) of the electromagnetically shielded container (500).

2. The cable entry arrangement (100) according to claim 1, wherein the at least one sealing member comprises an electrically conductive epoxy resin (525) connected to said cable shielding (210) and mechanically fixing the cable (200) in the channel (125).

3. The cable entry arrangement (100) according to claim 2, wherein the electrically conductive epoxy resin (525) comprises at least one of: copper, nickel and aluminum.

4. The cable entry arrangement (100) according to any of the preceding claims, wherein the at least one sealing member comprises an electrically conductive lid (300) mounted over the base member (115) to cover a portion of the cable shielding (210) located in the channel (125) and mechanically fixing the cable (200) in the channel (125).

5. The cable entry arrangement (100) according to claim 4, wherein the electrically conductive lid (300) is made, at least partially, of aluminum.

6. The cable entry arrangement (100) according to any of claims 4 or 5, wherein the electrically conductive lid (300) comprises a compressing member (310) configured to contact the cable shielding (210) of the cable (200) when the cable (200) is placed in the channel (125) and apply a pressure to the cable (200).

7. The cable entry arrangement (100) according to claim 6, wherein the compressing member (310) protrudes from an inside surface (330) of the electrically conductive lid (300), and the compressing member (310) comprises a groove surface (315) adapted to contact the cable shielding (210) when the cable (200) is placed in the channel (125).

8. The cable entry arrangement (100) according to claim 7, wherein the compressing member (310) is adapted to contact the cable shielding (210) of the cable (200) at said inlet end (126) when the cable (200) is placed in the channel (125) and close an electromagnetic shielding around the cable (200), which electromagnetic shielding is galvanically connected to the electromagnetically shielded container (500).

9. The cable entry arrangement (100) according to claim 8, wherein the compressing member extends along an entire length of the channel (125).

10. The cable entry arrangement (100) according to any of claims 7 to 9, wherein the groove surface (315) of the lid (300) comprises a serrated pattern (317) adapted to grip into the cable shielding (210) of the cable (200) when the cable (200) is placed in the channel (125) and the lid (300) is mounted over the base member (115).

11. The cable entry arrangement (100) according to any of claims 4 to 10, wherein
the electrically conductive lid (300) comprises at least one through-hole (301, 302, 303, 304, 305, 306) configured to receive a respective screw (601, 602, 603, 604, 605, 606), and
the base member (115) comprises at least one threaded hole (101, 102, 103, 104, 105, 106) matching the at least one through-hole (301, 302, 303, 304, 305, 306) when the electrically conductive lid (300) is mounted on the base member (115), which at least one threaded hole is adapted to receive the respective screws (601, 602, 603, 604, 605, 606) for fastening the electrically conductive lid (300) to the base member (115).

12. The cable entry arrangement (100) according to any of the preceding claims, wherein a contact surface of the channel (125) comprises a serrated pattern (417, 418), which contact surface is adapted to grip into the cable shielding (210) of the cable (200) when the cable (200) is placed in the channel (125).

13. The cable entry arrangement (100) according to any of the preceding claims, wherein the base member (115) forms an integral part of the wall (510) of the electromagnetically shielded container (500).

14. An electromagnetically shielded container (500) comprising electronic circuitry (710), **characterized in that** at least one wall (510) of said container (500) comprises at least one cable entry arrangement (100) according to any one of the preceding claims.

15. A satellite terminal (700) comprising:
the electromagnetically shielded container (500) according to claim 14, and
at least one cable (200) that is lead through at least one wall (510) of said container (500) via the at least one cable entry arrangement (100) defined in any of claims 1 to 13.
